# EUROPEAN PATENT SPECIFICATION

(11) **EP 3 320 548 B1**
(45) Date of publication and mention of the grant of the patent: **31.08.2022**
(21) Application number: 16820881.7
(22) Date of filing: 07.07.2016
(51) Int. Cl.: H01F 38/10, G03F 7/20, H05B 41/298, B41C 1/00, H05B 41/38, H05B 41/392

(54) **METHOD FOR CONTROLLING RADIATION EMITTING FROM ONE OR MORE TUBULAR LAMPS IN AN EXPOSURE APPARATUS**
VERFAHREN ZUR STEUERUNG DER STRAHLUNGSEMISSION AUS EINER ODER MEHREREN RÖHRENFÖRMIGEN LAMPEN IN EINER BELICHTUNGSVORRICHTUNG
PROCÉDÉ DE COMMANDE DU RAYONNEMENT ÉMIS PAR UNE OU PLUSIEURS LAMPES TUBULAIRES DANS UN APPAREIL D'EXPOSITION

(30) Priority: 08.07.2015 DK 201570453
(43) Date of publication of application: 16.05.2018
(73) Proprietor: Glunz & Jensen A/S, 4100 Ringsted (DK)
(72) Inventor: SPIES, Joachim, 4100 Ringsted (DK)
(74) Representative: Budde Schou A/S
(86) International application number: PCT/DK2016/050239
(87) International publication number: WO 2017/005271

(56) References cited:
- JP-A- H11 338 163
- JP-A- 2010 085 507
- JP-A- 2010 085 507
- US-A- 3 690 754
- US-A- 4 117 375
- US-A1- 2012 313 534
- US-A1- 2014 313 493
- US-A1- 2014 313 493

## Description

### FIELD OF THE INVENTION

This invention pertains to a method for controlling radiation emitting from one or more tubular lamps in an exposure apparatus for exposing a photosensitive element to the radiation. Specifically, the method involves adjusting an adjustable ballast connected to the one or more lamps thereby adjusting the power received by the one or more lamps, wherein adjusting the ballast of the one or more lamps is based on the actual temperature and radiation of the one or more lamps.

### BACKGROUND OF THE INVENTION

Flexographic printing plates are well known for use in relief printing on a variety of substrates such as paper, corrugated board, films, foils and laminates. Flexographic printing plates can be prepared from photosensitive elements containing a layer of a photosensitive composition such as those described in U.S. Patents 4,323,637 and 4,427,759. Photosensitive compositions (or photopolymerizable compositions) generally contain an elastomeric binder, at least one monomer, and a photoinitiator.

Photosensitive elements generally have the layer of the photopolymerizable composition interposed between a support and a cover sheet or multilayer cover element. Upon imagewise exposure of the photosensitive element to actinic radiation, photopolymerization of the photosensitive composition occurs in the exposed areas, thereby curing and rendering insoluble the exposed areas of the layer. The exposed element can be treated with a suitable solution or treated thermally to remove areas of the photopolymerizable layer that were not exposed which provides a printing relief suitable for use in flexographic printing.

The uniformity of the radiation emitting from each of the lamps is not constant over time, particularly over the lifetime of the lamps. During exposure, the radiation impinging the photosensitive element should be evenly distributed over the area of the exposure bed, so that the entire exposed surface of the photosensitive element is uniformly irradiated.

The plurality of light tubes when energized typically generates heat, which particularly in an enclosed environment interior to the exposure apparatus can influence the temperature of the lamps. So much heat may be generated by the lamps that the lamps overheat, and it can become difficult to maintain the lamps at a constant temperature or within a desired temperature range, causing fluctuations in emission level.

The emission level of UV lamps varies, depending on the particular lamp type used (even across different production batches from the same type of lamp), on the operation current and its frequency supplied by the lamp control unit.

The lamps age with use, where the irradiance emitted by a lamp or its intensity diminishes as the lamp is used. An integrator can be used to compensate for lamp aging to a certain degree, but either the exposures become too long or is insufficient to provide desired degree of photochemical reaction in the photosensitive element.

With ever increasing demands on quality, the current state-of-the-art flexographic printing forms may not perform as desired and have trouble meeting the ever increasing demands on quality. Exposure times vary from a few seconds to a several minutes depending upon the output of the actinic radiation source (hereafter referred to as the "lamp(s)", distance from the lamps, desired relief depth, and the thickness of the photosensitive element. Since the photosensitive element is exposed to actinic radiation at three different steps in its conversion to a relief printing form, which includes a back exposure through the support, and image-wise exposure through the mask, and a post-exposure and finishing exposure, it is particularly desirable to create and maintain uniform conditions in the exposure apparatus so that the photosensitive element experiences consistent environment and uniform distribution of actinic radiation during each of these exposures.

US2014/0313493 discloses an exposure apparatus comprising a central control unit for controlling the output of the tubular lamps by adjusting ballast. The central control unit regulates the light intensity based on the temperature of the lamps and based on controlling the ballast. This regulation therefore uses signals from sensors that either measure the lamp temperature or the intensity of the radiation of the lamps. While the regulation performed in US2014/0313493 does take into account that the intensity of the lamps varies over time it does not perform a pre-characterization determining the output of the one or more lamps as a function of lamp current and temperature. There is a need for an improved regulation which takes these matters into account.

### SUMMARY OF THE INVENTION

The present invention provides a method for controlling the lamp emission level in accordance with a defined set of operating conditions regarding the operating temperature, the lamp current and the lamp frequency.

Specifically there is provided a method for controlling radiation emitting from one or more tubular lamps in an exposure apparatus for exposing a photosensitive element to the radiation, said apparatus comprising an adjustable ballast connected to the one or more lamps for adjusting the power received by the one or more lamps, wherein adjusting the ballast of the one or more lamps is based on a pre-characterization of the one or more lamps, wherein the output of the one or more lamps has been determined by the Central Control Unit, as a function of lamp current and temperature, optionally over the life time, of the one or more lamps, whereby the lamp control unit is configured to adjust the ballast of the one or more lamps based on the basis of said pre-characterization to achieve a lamp output in the range of 15 to 25 mWatt/cm2, preferably 18 to 22 mWatt/cm2.

Preferably the output of the one or more lamps has been determined over the life time t of the one or more lamps.

In a preferred embodiment the temperature of the one or more lamps is measured in a distance from the one or more lamps of 0-30cm, such as directly on the lamp surface.

The method may further comprise the step of placing the photosensitive element on an exposure bed or in proximity to the one or more lamps in a distance of 1-5cm, and exposing the photosensitive element to the radiation irradiating from the one or more lamps after adjusting the power to the ballast in accordance with the scheme of claim 1. In a further aspect of the invention, there is provided an exposure apparatus according to claim 8.

The one or more lamps may comprise a plurality of tubular lamps that are adjacent and parallel to each other, and further comprising measuring irradiance emitting from the one or more lamps in proximity (i.e. 1-5cm) to the one or more lamps.

### BRIEF DESCRIPTION OF THE DRAWINGS

FIG. 1 shows two lamp configurations of the present invention.
FIG. 2 shows graphs of lamp current adjustments over the duty cycle.
FIG. 3 shows UV-A output over lamp temperature, at different lamp current levels.
FIG. 4 shows a block diagram over the exposure system.

### DETAILED DESCRIPTION OF THE INVENTION

The invention will now be explained in more detail with reference to an embodiment in which the exposure device comprises one or more of the following functional elements:
- A carrier plate for the photosensitive substrate which is temperature-controlled in order to control the substrate temperature during exposure.
- A cooling system used to control the carrier plate temperature (cooled bed).
- A transparent carrier plate for the photosensitive substrate in order to allow double-sided exposure.
- A set of adjacent light bulbs, mounted on top and/or below the photosensitive substrate.
- Minimum one temperature sensors to monitor and to control the lamp temperature.
- A cooling system used to control the lamp temperature.
- Minimum one UV-light sensor in order to monitor and to control the UV energy applied to the substrate.
- Minimum one ballast used to provide an adjustable lamp current to the lamp(s). As an alternative, a ballast with a fixed lamp current output can used. The fixed lamp current level is based on the below mentioned dataset.
- A central control unit that provides the input to the one or more adjustable ballasts, in order for them to provide the optimum lamp current according to the below mentioned dataset.
- A generic dataset established for each lamp type and/or batch, defining the UV emission level as a function of time, lamp current, and temperature.

This dataset is then used to set the optimum lamp current provided by the adjustable ballast, depending on actual output status of the lamp, which is derived from the generic dataset

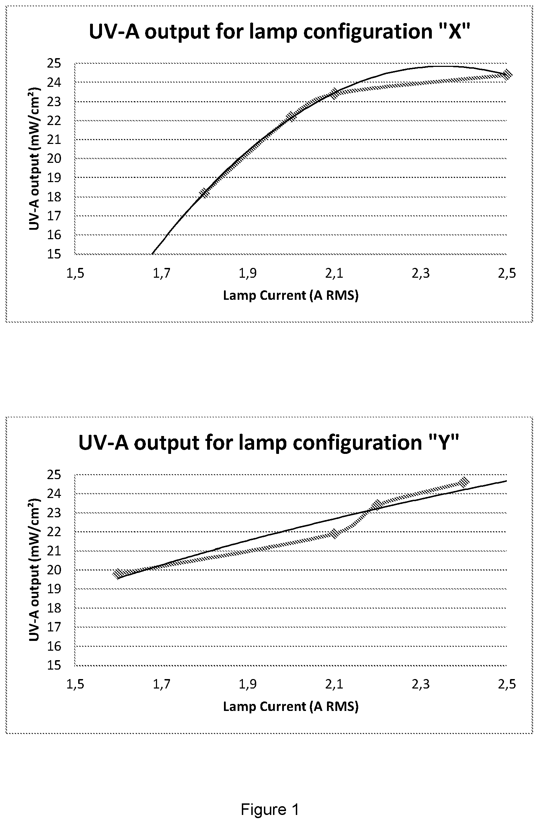

Examples for such generic dataset are as follows:
Referring to Figure 1 there is shown the relation between the lamp current provided by the ballast, and the resulting UV-A output. The two lamp configurations shown (specific ballast + specific lamp type, X+Y) exhibit different characteristics. This generic information may be used to adjust the lamp current to an optimum level, depending on the UV-A output requirement. In the configuration "X", the lamp current for maximum output would be set to appr. 2,1A. If the extended lifetime is desired the optimum lamp current could be set to appr. 1,8A.

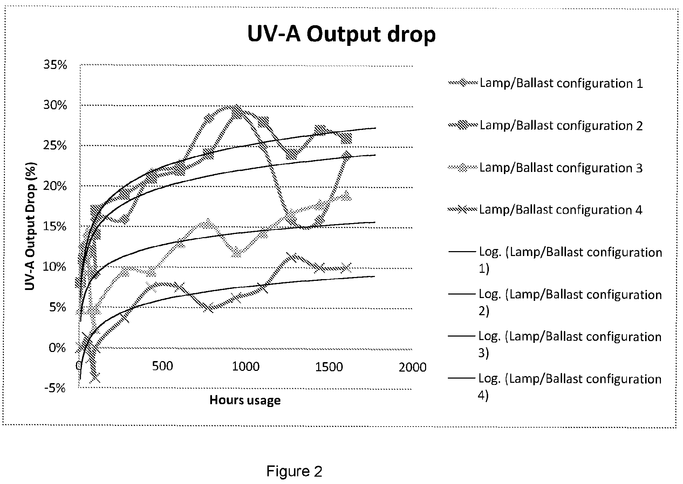

Referring to Figure 2 there is shown a drop (in % from starting level) in UV-A output over time, at 100% duty cycle. All 4 configurations indicate individual characteristics, which can be shown as logarithmic functions. Based on these functions, the lamp current can be adjusted over duty cycle time in order to compensate for the shown drop.

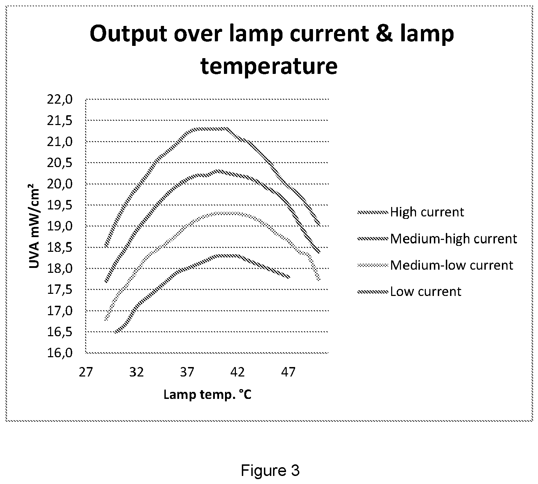

Referring to Figure 3 there is shown UV-A output over lamp temperature, at different lamp current levels. This temperature characteristic is varying slightly from lamp type to lamp type. Such knowledge is important in order to determine and ensure optimum temperature conditions for each individual lamp type.

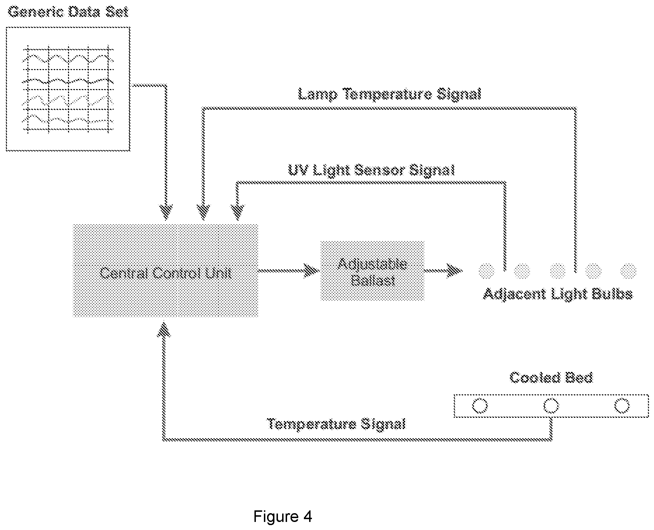

Finally, for illustrative purposes reference is made to Figure 4, which is a block diagram over the exposure system.

## Claims

1. A method for controlling radiation emitting from one or more tubular lamps in an exposure apparatus for exposing a photosensitive element to the radiation, said apparatus comprising a central control unit and an adjustable ballast connected to the one or more lamps for adjusting the power received by the one or more lamps, wherein the method comprises the step of adjusting the ballast of the one or more lamps is based on a pre-characterization of the one or more lamps, **characterized in that** said pre-characterization determining the output of the one or more lamps has been determined as a function of lamp current and temperature, optionally over the life time, of the one or more lamps, whereby the central control unit is configured to adjust the ballast of the one or more lamps based on the basis of said pre-characterization to achieve a lamp output in the range of 15 to 25 mWatt/cm2 .

2. The method of claim, wherein said pre-characterization determining the output of the one or more lamps has been determined over the life time of the one or more lamps.

3. The method of claims 1 or 2, wherein the temperature of the one or more lamps is measured in a distance from the one or more lamps of 0-30cm.

4. The method of any one of the claims 1-3 further comprising placing the photosensitive element on an exposure bed, and exposing the photosensitive element to the radiation irradiating from the one or more lamps after adjusting the power to the ballast in accordance with the scheme of claim 1.

5. The method of any one of the claims 1-4, wherein the target irradiance is 18 to 22 mWatt/cm2.

6. The method of any one of the claims 1-5, wherein the one or more lamps comprises a plurality of tubular lamps that are adjacent and parallel to each other, and further comprising measuring irradiance emitting from the one or more lamps at a distance of 2 to 4 cm from the one or more lamps.

7. The method of any one of the claims 1-6, wherein the exposure apparatus for exposing a photosensitive element to the radiation has a cooled bed configuration.

8. An exposure apparatus comprising:
- an adjustable ballast connected to one or more tubular lamps for adjusting the power received by the one or more lamps,
- a control unit for adjusting the ballast of the one or more lamps based on a pre-characterization of the one or more lamps, **characterized in that** the output of the one or more lamps has been determined as a function of lamp current and temperature , optionally over the life time, of the one or more lamps, whereby the central control unit is configured to adjust the ballast of the one or more lamps based on the basis of said pre-characterization to achieve a lamp output in the range of 15 to 25 mWatt/cm2 .

9. The exposure apparatus according to claim 8, wherein the control unit is configured to implement the method of any one of the claims 1-7.

## Patentansprüche

1. Verfahren zur Steuerung der Strahlungsemission aus einer oder mehreren röhrenförmigen Lampen in einer Belichtungsvorrichtung zum Belichten eines lichtempfindlichen Elements mit der Strahlung, wobei die Vorrichtung eine zentrale Steuereinheit und ein einstellbares Vorschaltgerät umfasst, das mit der einen oder den mehreren Lampen verbunden ist, um die von der einen oder den mehreren Lampen empfangene Leistung einzustellen, wobei das Verfahren den Schritt des Einstellens des Vorschaltgeräts der einen oder mehreren Lampen basierend auf einer Vorcharakterisierung der einen oder mehreren Lampen umfasst, **dadurch gekennzeichnet, dass** die Vorcharakterisierung, die die Leistung der einen oder mehreren Lampen bestimmt, als eine Funktion des Lampenstroms und der Temperatur, optional über die Lebensdauer, der einen oder mehreren Lampen bestimmt worden ist, wobei die zentrale Steuereinheit konfiguriert ist, das Vorschaltgerät der einen oder mehreren Lampen basierend auf der Vorcharakterisierung einzustellen, um eine Lampenleistung im Bereich von 15 bis 25 mWatt/cm2 zu erreichen.

2. Verfahren nach Anspruch, wobei die Vorcharakterisierung, die die Leistung der einen oder mehreren Lampen bestimmt, über die Lebensdauer der einen oder mehreren Lampen bestimmt worden ist.

3. Verfahren nach Anspruch 1 oder 2, wobei die Temperatur der einen oder mehreren Lampen in einem Abstand von 0-30 cm von der einen oder mehreren Lampen gemessen wird.

4. Verfahren nach einem der Ansprüche 1 bis 3, ferner umfassend das Platzieren des lichtempfindlichen Elements auf einem Belichtungsbett und das Belichten des lichtempfindlichen Elements mit der Strahlung, die von der einen oder den mehreren Lampen ausgestrahlt wird, nachdem die Leistung des Vorschaltgeräts gemäß dem Schema von Anspruch 1 eingestellt wurde.

5. Verfahren nach einem der Ansprüche 1 bis 4, wobei die Zielbestrahlungsstärke 18 bis 22 mWatt/cm2 beträgt.

6. Verfahren nach einem der Ansprüche 1-5, wobei die eine oder mehreren Lampen eine Vielzahl von röhrenförmigen Lampen umfassen, die benachbart und parallel zueinander sind, und ferner umfassend das Messen der Bestrahlungsstärke, die von der einen oder den mehreren Lampen in einem Abstand von 2 bis 4 cm von der einen oder mehreren Lampen entfernt emittiert wird.

7. Verfahren nach einem der Ansprüche 1 bis 6, wobei die Belichtungsvorrichtung zum Belichten eines lichtempfindlichen Elements mit der Strahlung eine Konfiguration mit gekühltem Bett aufweist.

8. Belichtungsvorrichtung, umfassend:
- ein einstellbares Vorschaltgerät, das mit einer oder mehreren röhrenförmigen Lampen verbunden ist, um die von der einen oder mehreren Lampen empfangene Leistung einzustellen,
- eine Steuereinheit zum Einstellen des Vorschaltgeräts der einen oder mehreren Lampen basierend auf einer Vorcharakterisierung der einen oder mehreren Lampen, **dadurch gekennzeichnet, dass** die Leistung der einen oder mehreren Lampen als eine Funktion von Lampenstrom und -temperatur bestimmt worden ist, optional über die Lebensdauer der einen oder mehreren Lampen, wobei die zentrale Steuereinheit konfiguriert ist, das Vorschaltgerät der einen oder mehreren Lampen basierend auf der Vorcharakterisierung einzustellen, um eine Lampenleistung im Bereich von 15 bis 25 mWatt/cm2 zu erreichen.

9. Belichtungsvorrichtung nach Anspruch 8, wobei die Steuereinheit so konfiguriert ist, dass sie das Verfahren nach einem der Ansprüche 1-7 implementiert.

## Revendications

1. Procédé de commande du rayonnement émis par une ou plusieurs lampes tubulaires dans un appareil d'exposition pour exposer un élément photosensible au rayonnement, ledit appareil comprenant une unité de commande centrale et un ballast réglable relié aux une ou plusieurs lampes pour régler la puissance reçue par les une ou plusieurs lampes, dans lequel le procédé comprend l'étape de réglage du ballast des une ou plusieurs lampes sur la base d'une pré-caractérisation des une ou plusieurs lampes, **caractérisé en ce que** ladite pré-caractérisation déterminant la sortie des une ou plusieurs lampes a été déterminée en fonction du courant et de la température de la lampe, éventuellement sur la durée de vie, des une ou plusieurs lampes, moyennant quoi l'unité de commande centrale est configurée pour régler le ballast des une ou plusieurs lampes en fonction de la base de ladite pré-caractérisation pour obtenir une sortie de lampe dans la plage de 15 à 25 mWatt/cm2.

2. Procédé selon la revendication, dans lequel ladite pré-caractérisation déterminant la sortie des une ou plusieurs lampes a été déterminée sur la durée de vie des une ou plusieurs lampes.

3. Procédé selon les revendications 1 ou 2, dans lequel la température des une ou plusieurs lampes est mesurée dans une distance des une ou plusieurs lampes de 0 à 30 cm.

4. Procédé selon l'une quelconque des revendications 1 à 3, comprenant en outre le placement de l'élément photosensible sur un lit d'exposition, et l'exposition de l'élément photosensible au rayonnement irradiant des une ou plusieurs lampes après le réglage de la puissance du ballast conformément au schéma selon la revendication 1.

5. Procédé selon l'une quelconque des revendications 1 à 4, dans lequel l'irradiance cible est de 18 à 22 mWatt/cm2.

6. Procédé selon l'une quelconque des revendications 1 à 5, dans lequel les une ou plusieurs lampes comprennent une pluralité de lampes tubulaires qui sont adjacentes et parallèles les unes aux autres, et comprenant en outre la mesure de l' irradiance émise par les une ou plusieurs lampes à une distance de 2 à 4 cm des une ou plusieurs lampes.

7. Procédé selon l'une quelconque des revendications 1 à 6, dans lequel l'appareil d'exposition pour exposer un élément photosensible au rayonnement a une configuration de lit refroidi.

8. Appareil d'exposition comprenant :
- un ballast réglable relié à une ou plusieurs lampes tubulaires pour régler la puissance reçue par les une ou plusieurs lampes,
- une unité de commande pour régler le ballast des une ou plusieurs lampes sur la base d'une pré-caractérisation des une ou plusieurs lampes, **caractérisé en ce que** la sortie des une ou plusieurs lampes a été déterminée en fonction du courant et de la température de la lampe, éventuellement sur la durée de vie, des une ou plusieurs lampes, moyennant quoi l'unité de commande centrale est configurée pour régler le ballast des une ou plusieurs lampes en fonction de la base de ladite pré-caractérisation pour obtenir une sortie de lampe dans la plage de 15 à 25 mWatt/cm2.

9. Appareil d'exposition selon la revendication 8, dans lequel l'unité de commande est configurée pour mettre en œuvre le procédé selon l'une quelconque des revendications 1 à 7.
